**Europäisches Patentamt**

**European Patent Office**

**Office européen des brevets**

(19)

(11) Veröffentlichungsnummer: **0 167 667**
**B1**

(12) # EUROPÄISCHE PATENTSCHRIFT

(45) Veröffentlichungstag der Patentschrift:
02.09.87

(51) Int. Cl.⁴: **H 02 B 11/02, H 05 K 7/14**

(21) Anmeldenummer: **84114394.4**

(22) Anmeldetag: **28.11.84**

(54) Gekapseltes elektrisches Schaltfeld.

(30) Priorität: **07.06.84 DE 3421224**

(43) Veröffentlichungstag der Anmeldung:
**15.01.86 Patentblatt 86/3**

(45) Bekanntmachung des Hinweises auf die Patenterteilung:
**02.09.87 Patentblatt 87/36**

(84) Benannte Vertragsstaaten:
**AT BE CH DE FR GB IT LI NL**

(56) Entgegenhaltungen:
**EP-A-0 038 583**
**US-A-3 343 042**
**US-A-4 071 722**

(73) Patentinhaber: **Siemens Aktiengesellschaft Berlin und München, Wittelsbacherplatz 2, D-8000 München 2 (DE)**

(72) Erfinder: **Genzel, Rolf- Günter, Dipl., Ing., Forstring 32, D-6070 Langen (DE)**
Erfinder: **Rössler, Karl- Heinz, Wilhelmsbader Strasse 23, D-6457 Maintal 1 (DE)**

## Beschreibung

Die Erfindung bezieht sich auf ein gekapseltes elektrisches Schaltfeld nach dem Oberbegriff des Anspruches 1.

Es ist bereits ein elektrisches Schaltfeld der im Oberbegriff des Anspruches 1 genannten Art bekannt. Aus dem bekannten Schaltfeld sind jedoch keine Maßnahmen nahegelegt, wie eine Bewegung des Einziehhebels verhinderbar ist, wenn die Steckelemente und die Gegensteckelemente aus Grüden der elektrischen Sicherheit auf keinen Fall entweder nicht voneinander getrennt oder nicht miteinander verbunden werden dürfen (DE-U-17 34 677).

Es ist auch bereits ein Schaltschrank bekannt, bei dem ein Einschub einen Drehschalter mit einem Triebstock trägt, mit dem ein auf dem Einschub befindlicher zweiarmiger Verriegelungshebel in Schaltrichtung "Aus" in eine das freie Verschieben des Einschubes gestattende Lage und in Schaltrichtung "Ein" in einen Verriegelungseingriff mit einem ortsfesten Schaltschrankelement bewegbar ist (DE-C-30 15 259).

Aufgabe der Erfindung ist es, das gekapselte elektrische Schaltfeld der Gattung des Oberbegriffes des Anspruches 1 auf besonders einfache Weise so auszubilden, daß der Einziehhebel nur bewegbar ist, wenn die Steckelemente und Gegensteckelemente gefahrlos miteinander verbunden oder voneinander getrennt werden können. Die Ausbildung soll ferner so sein, daß die Möglichkeit des Trenners der Steckelemente und der Gegensteckelemente an der Stellung des Einziehhebels erkennbar ist.

Die gestellte Aufgabe wird erfindungsgemäß durch die im kennzeichnenden Teil des Anspruches 1 angegebene Ausbildung gelöst.

Zweckmäßige Aus- und Weiterbildungen des Erfindungsgegenstandes sind in den Ansprüchen 2 bis 5 angegeben.

Ein Ausführungsbeispiel der Erfindung ist in der Zeichnung rein schematisch gezeigt. Es zeigen:

Fig. 1 in perspektivischer Darstellung einen Einschub mit einem in die Einschubfront eingeschwenkten Einziehhebel,

Fig. 2 eine perspektivische Darstellung wie in Fig. 1, jedoch mit ausgeschwenktem Einziehhebel.

In der Zeichnung ist mit 1 ein Einschub eines mit Ausnahme einer Schaltfeldschiene 2 und einer Schaltfeldtür 8 im übrigen nicht dargestellten gekapselten elektrischen Schaltfeldes bezeichnet.

Der Einschub 1 trägt in üblicher Weise auf seiner aus der Zeichnung nicht ersichtlichen Rückfront Steckelemente für im Schaltfeld angeordnete Gegensteckelemente.

Ferner trägt der Einschub 1 einen um eine horizontale Achse 3 schwenkbaren Einziehhebel 4, der einerseits der Achse 3 einen aus der Front des Einschubes 1 heraus- und zurückschenkbaren Kraftarm 4a aufweist.

Andererseits der Achse 3 befindet sich ein Lastarm 4b des Hebels 4. Der Lastarm 4b ist mit einer Ausnehmung 5 der Schaltfeldschiene 2 in Eingriff bringbar. Die Ausnehmung 5 zeigt eine vordere Begrenzungskante 5a und eine hintere Begrenzungskante 5b.

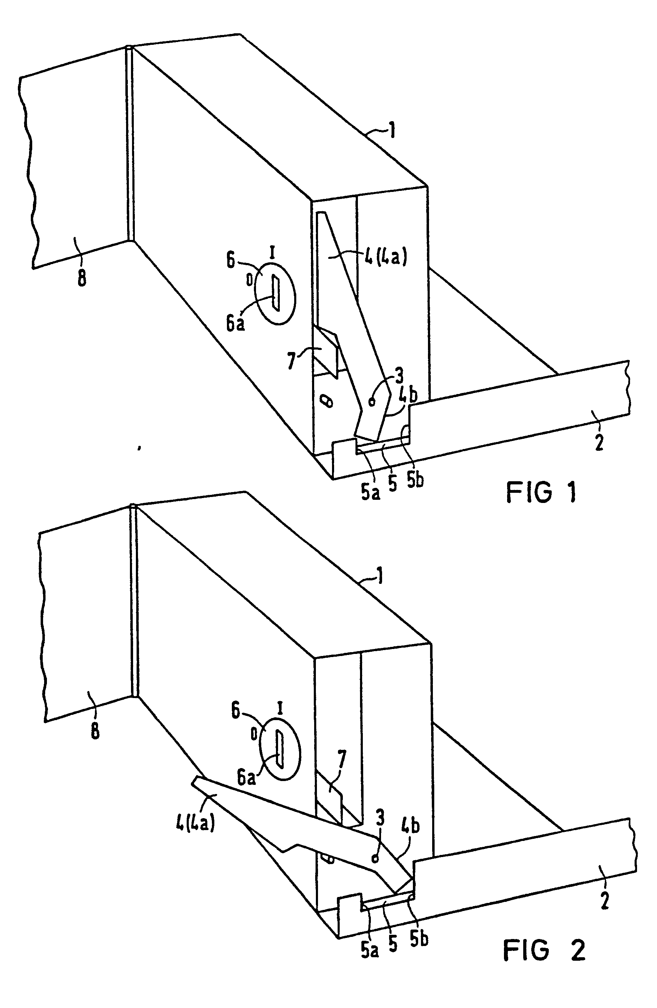

Beim Ausschwenken des Kraftarmes 4a des Einziehhebels 4 aus der Einschubfront, durchläuft der Lastarm 4b des Hebels 4 frei die Ausnehmung 5 der Schaltfeldschiene 2, bis er an der hinteren Begrenzungskante 5b der Schaltfeldschiene 2 angreift (Fig. 2). Wird nun der Kraftarm 4a begonnenen Richtung weitergeschwenkt, drückt der Lastarm 4b des Hebels 4 den Einschub 1 nach vorne, wobei die Steckelemente und Gegensteckelemente voneinander getrennt werden.

Das Einziehen des Einschubes in das Schaltfeld erfolgt in umgekehrter Weise mit dem Unterschied, daß der Lastarm 4b des Hebels 4 dabei nicht an der hinteren Begrenzungskante 5b sondern an der vorderen Begrenzungskante 5a der Ausnehmung 5 der Schaltfeldschiene 2 angreift.

Der Einschub 1 ist mit einem Drehschalter 6 ausgerüstet, dessen Handhabe 6a in der Einschubfront liegt.

Damit die Steckelemente und Gegensteckelemente in der Betriebsstellung des Einschubes 1 bei eingeschaltetem Drehschalter 6 nicht voneinander getrennt werden können, ist der Kraftarm 4a des Einziehhebels 4 durch einen Riegel 7 sperrbar, der beim Einschalten des Drehschalters 6 in den Schwenkweg des Kraftarmes 4a des Einziehhebels 4 bewegbar ist (Fig.1). Im dargestellten Beispiel ist der Riegel 7 unmittelbar auf der nicht dargestellten Schalterachse befestigt. In nicht gezeigter Weise kann jedoch zwischen der Schalterachse und dem Riegel 7 ein Getriebe vorgesehen sein, mit dem eine Bewegung der Schalterachse auf den Riegel 7 übertragbar ist.

Der Kraftarm 4a des Einziehhebels 4 ist so ausgebildet, daß er nach der Freigabe durch den Riegel 7 alleine durch sein Eigengewicht bis zur Anlage des Lastarmes 4b an der hinteren Begrenzungskante 5b der Ausnehmung 5 der Schaltfeldschiene frei aus der Einschubfront herausschwenkbar ist. Bei ausgeschwenktem Kraftarm 4a ist optisch sofort erkennbar, daß der Drehschalter 6 in der Betriebsstellung des Einschubes 1 ausgeschaltet ist. Damit das Eigengewicht des Kraftarmes 4a des Einziehhebels 4 in der beschriebenen Weise zur Wirkung kommt, liegt der Schwerpunkt des Kraftarmes 4a vor der Achse 3.

Die elektrische Sicherheit erfordert es, daß der Einschub 1 bei eingeschaltetem Drehschalter 6 nicht in seine Betriebsstellung bewegbar ist. Zur Erfüllung dieser Forderung ist vorgesehen, daß der Riegel 7 außerhalb der Betriebsstellung des Einschubes 1 bei eingeschaltetem Drehschalter 6 im Rückschwenkweg des herausgeschwenkten Kraftarmes 4a des Einziehhebels 4 liegt (Fig.2). Während der Kraftarm 4a des Einziehhebels 4 gegen Rückschwenken gesperrt ist, bilden der Lastarm 4b des Einziehhebels 4 und die hintere Begrenzungskante 5b der Ausnehmung 5 der Schaltfeldschiene 2 ein Gesperre gegen das Bewegen des Einschubes 1 in seine Betriebsstellung.

Die im dargestellten Beispiel dargestellte Schaltfeldtür 8 ist so angeordnet, daß sie geschlossen den Einziehhebel 4 in der Einschubfront hält, wenn der Drehschalter 6 ausgeschaltet ist. Beim Öffnen der Tür 8 fällt der Kraftarm 4a des Einziehhebels 4 aus der Einschubfront heraus und zeigt so an, daß der Drehschalter 6 ausgeschaltet und der Einschub 1 aus seiner Betriebsstellung bewegbar ist.

Mit dem Schließen der Schaltfeldtür 8 ist der Kraftarm 4a des Einziehhebels 4 auch wieder in die Einschubfront zurückschwenkbar, wenn der Drehschalter 6 ausgeschaltet ist. Bei eingeschaltetem Drehschalter 6 läßt sich die Schaltfeldtür 8 nicht schließen, da der Kraftarm 4a des Einziehhebels 4 in ihrem Rückschwenkweg liegt.

Damit der Drehschalter 6 auch bei geschlossener Schaltfeldtür 8 geschaltet werden kann, ist in der Schaltfeldtür 8 in nicht dargestellter Weise eine Öffnung vorgesehen, durch die die Handhabe 6a des Drehschalters 6 auch bei geschlossener Tür 8 betätigt werden kann.

In ebenfalls nicht dargestellter Weise ist zweckmäßig in der Schaltfeldtür 8 ein Sichtfenster angeordnet, durch das bei geschlossener Tür 8 und eingeschaltetem Drehschalter 6 die Stellung des Riegels 7 erkennbar ist Das freie Ende des Riegels 7 ist für eine bessere Erkennbarkeit zweckmäßig rot angelegt.

**Patentansprüche**

1. Gekapseltes elektrisches Schaltfeld, mit den Merkmalen:

1.1 das Schaltfeld ist mit mindestens einem Einschub (1) ausgerüstet, der Steckelemente für im Schaltfeld ortsfest angeordnete Gegensteckelemente sowie einen um eine horizontale Achse (3) schwenkbaren Einziehhebel (4) trägt;

1.2 der Einziehhebel (4) hat einerseits der Achse (3) einen aus der Einschubfront heraus und zurück schwenkbaren Kraftarm (4a) und andererseits der Achse (3) einen Lastarm (4b), der mit einer in einer ortsfesten Schaltfeldschiene (2) angeordneten Ausnehmung (5) in Eingriff bringbar ist, die eine vordere Begrenzungskante (5a) und eine hintere Begrenzungskante (5b) zeigt;

1.3 beim Ausschwenken des Kraftarmes (4a) des Einziehhebels (4) ist der Einschub (1) aus seiner Betriebsstellung bewegbar, wobei der Lastarm (4b) an der hinteren Begrenzungskante (5b) der Ausnehmung (5) der Schaltfeldschiene (2) angreift;

1.4 beim Zurückschwenken des Kraftarmes (4a) des Einziehhebels (4) ist der Einschub (1) in seine Betriebsstellung bewegbar, wobei der Lastarm (4b) an der vorderen Begrenzungskante (5a) der Ausnehmung (5) der Schaltfeldschiene (2) angreift,

gekennzeichnet durch die Merkmale:

1.5 der Kraftarm (4a) des Einziehhebels (4) ist gegen Herausschwenken aus der Einschubfront durch einen Riegel (7) sperrbar, der beim Einschalten eines auf dem Einschub (1) angeordneten Drehschalters (6) zwangsweise in den Schwenkweg des Kraftarmes (4a) bewegbar ist;

1.6 der entsperrte Kraftarm (4) ist alleine durch sein Eigengewicht bis zur Anlage des Lastarmes (4b) an der hinteren Begrenzungskante (5b) der Ausnehmung (5) der Schaltfeldschiene (2) frei aus der Einschubfront herausschwenkbar;

1.7 außerhalb der Betriebsschtellung des Einschubes (1) liegt der Riegel (7) bei eingeschaltetem Schalter (6) im Rüschwenkweg des herausgeschwenkten Kraftarmes (4a) des Einziehhebels (4), währenddessen der Lastarm (4b) des Einziehhebels (4) zusammen mit der hinteren Begrenzungskante (5b) der Ausnehmung (5) der ortsfesten Schaltfeldschiene (2) ein Gesperre gegen Bewegen des Einschubes (1) in die Betriebsschtellung bildet.

2. Schaltfeld nach Anspruch 1, dadurch gekennzeichnet, daß der Riegel (7) unmittelbar auf der Achse des Drehschalters (6) angeordnet ist.

3. Schaltfeld nach Anspruch 1 oder 2, dadurch gekennzeichnet, daß der Kraftarm (4a) des Einziehhelbels (4) durch eine vor ihm angeordnete Schaltfeldtür (8) in der Einschubfront haltbar und in die Einschubfront bewegbar ist.

4. Schaltfeld nach einem der Ansprüche 1 bis 3, dadurch gekennzeichnet, daß die Schaltfeldtür (8) eine Ausnehmung aufweist, durch die der Drehschalter (6) bei geschlossener Tür (8) betätigbar ist.

5. Schaltfeld nach einem der Ansprüche 1 bis 4, dadurch gekennzeichnet, daß die Schaltfeldtür ein Sichtfenster aufweist, durch das bei geschlossener Tür und eingeschaltetem Drehschalter (6) die Sperrstellung des Riegels (7) erkennbar ist.

**Claims**

1. Enclosed electrical switch panel with the features:

1.1 the switch panel is provided with at least one plug-in unit (1) which carries connector elements for complementary connector elements fixedly arranged in the switch panel, and also a pull lever (4) which is pivotable about a horizontal shaft (3);

1.2 the pull lever (4) has on one side of the shaft (3) a power arm (4a), which can be swung out from the front of the plug-in unit and back, and on the other side of the shaft (3) a work arm (4b) which is engageable with a recess (5) arranged in a fixed switch panel rail (2), which recess (5) has a front boundary edge (5a) and a rear boundary edge (5b);

1.3 by swinging out the power arm (4a) of the pull lever (4), the plug-in unit (1) is movable out of its operating position, as the work arm (4b) acts on the rear boundary edge (5b) of the recess (5) of the switch panel rail (2);

1.4 by swinging the power arm (4a) of the pull lever (4) back, the plug-in unit (1) is movable into its operating position, as the work arm (4b) acts on the front boundary edge (5a) of the recess (5) of the switch panel rail (2);

characterised by the features:

1.5 the power arm (4a) of the pull lever (4) can be prevented from swinging out from the front of the plug-in unit by a bar (7) which, by engagement of a rotary actuator (6) arranged on the plug-in unit (1), can be forced to move into the swing path of the power arm (4a);

1.6. the unblocked power arm (4) can swing out freely by itself, under its own weight, from the front of the plug-in unit until the work arm (4b) lies against the rear boundary edge (5b) of the recess (5) of the switch panel rail (2);

1.7 when the plug-in unit (1) is out of its operating position, with the actuator (6) engaged, the bar (7) lies in the path of the return swing of the swung out power arm (4a) of the pull lever (4), while the work arm (4b) of the pull lever (4) together with the rear boundary edge (5b) of the recess (5) of the fixed switch panel rail (2) forms a block against movement of the plug-in unit (1) into the operating position.

2. Switch panel according to claim 1, characterised in that the bar (7) is arranged directly on the shaft of the rotary actuator (6).

3. Switch panel according to claim 1 or 2, characterised in that the power arm (4a) of the pull lever (4) can be kept in the front of the plug-in unit by a switch panel door (8) arranged in front of it and can be moved into the front of the plug-in unit.

4. Switch panel according to one of claims 1 to 3, characterised in that the switch panel door (8) has a recess through which the rotary actuator (6) can be operated when the door (8) is closed.

5. Switch panel according to one of claims 1 to 4, characterised in that the switch panel door has a display window through which, when the door is closed and the rotary actuator (6) is engaged, it is possible to see the blocking position of the bar (7).

**Revendications**

1. Tableau de distribution électrique blindé, possédant les caractéristiques:

1.1 le tableau de distribution est équipé d'au moins un tiroir (1), qui porter des organes d'enfichage pour des organes antagonistes d'enfichage montés fixes dans le tableau de distribution, ainsi qu'un levier rétractable (4) pouvant pivoter autour d'un axe horizontal (3);

1.2 le levier rétractable (4) comporte, d'un côté de l'axe (3), un bras de force (4a) pouvant être ressorti sur l'avant du tiroir et être rétracté par rapport à l'avant du tiroir, et, de l'autre côté de l'axe (3), un bras de charge (4b) qui peut être amené à s'engager dans un évidement (5) disposé dans un rail fixe (2) du tableau de distribution et qui possède un bord limite avant (5a) et un bord limite arrière (5b);

1.3 lors du pivotement du bras de force (4a) du levier rétractable (4), le tiroir (1) peut être écarté de sa position de service, auquel cas le bras de force (4b) attaque le bord limite arrière (5b) de l'évidement (5) du rail (2) du tableau de distribution;

1.4 lors du retrait par pivotement du bras de force (4a) du levier rétractable (4), le tiroir (1) peut être amené dans sa position de service, auquel cas le bras de charge (4b) attaque le bord limite avant (5a) de l'évidement (5) du rail (2) du tableau de distribution,

remarquable par les caractéristiques :

1.5. le bras de force (4a) du levier rétractable (4) peut être bloqué contre un pivotement le faisant sortir à partir de l'avant du tiroir, par un verrou (7), qui, lors du branchement du commutateur rotatif (6) disposé sur le tiroir (1), peut être déplacé à force sur le trajet de pivotement du bras de force (4a);

1.6 le bras de force débloqué (4) peut pivoter librement, en sortant de la face avant du tiroir, sous l'effet de son poids propre, jusqu'à ce que le bras de charge (4b) s'applique contre le bord limite arrière (5b) de l'évidement (5) du rail (2) du tableau de distribution;

1.7 lorsque le tiroir (1) n'est pas dans la position de service, le commutateur (6) étant branché, le verrou (7) est situé dans la voie de pivotement en retour du bras de force (4a), ressorti par pivotement, du levier rétractable (4), tandis que le bras de charge (4b) du levier rétractable (4) forme, en association avec le bord limite arrière (5b) de l'évidement (5) du rail fixe (2) du tableau de distribution, un dispositif d'arrêt contre tout déplacement du tiroir (7) dans la position de service.

2. Tableau de distribution suivant la revendication 1, caractérisé par le fait que le verrou (7) est monté directement sur l'axe du commutateur rotatif (6).

3. Tableau de distribution suivant la revendication 1 ou 2, caractérisé par le fait que le bras de force (4a) du levier rétractable (4) peut être retenu dans la face avant du tiroir, au moyen d'une porte (8) du tableau de distribution, qui est disposé devant ce bras, et peut être déplacé sur la face avant du tiroir.

4. Tableau de distribution suivant l'une des revendications 1 à 3, caractérisé par le fait que la porte (8) du tableau de distribution comporte un évidement, à travers lequel le commutateur rotation (6) peut être actionné lorsque la porte (6, 8) est fermée.

5. Tableau de distribution suivant l'une des revendications 1 à 4, caractérisé par le fait que la porte du tableau de distribution comporte une fenêtre qui permet de reconnaître la position de blocage du verrou (7) lorsque la porte est fermée et que le commutateur rotatif (6) est branché.

FIG 1

FIG 2